# EUROPÄISCHE PATENTSCHRIFT

(11) **EP 2 862 250 B1**
(45) Veröffentlichungstag und Bekanntmachung des Hinweises auf die Patenterteilung: **13.07.2016**
(21) Anmeldenummer: 13719880.0
(22) Anmeldetag: 03.05.2013
(51) Int. Cl.: H02G 3/22, H02G 3/06, H02G 3/08

(54) **DURCHFÜHRUNGSVORRICHTUNG FÜR EIN EXPLOSIONSGESCHÜTZTES GEHÄUSE**
LEAD-THROUGH DEVICE FOR A EXPLOSION-PROOF HOUSING
DISPOSITIF DE TRAVERSÉE POUR UN BOÎTIER ANTIDÉFLAGRANT

(30) Priorität: 13.06.2012 DE 102012105113
(43) Veröffentlichungstag der Anmeldung: 22.04.2015
(73) Patentinhaber: R. Stahl Schaltgeräte GmbH, 74638 Waldenburg (DE)
(72) Erfinder: WONDRAK, Tom, 74653 Künzelsau (DE)
(74) Vertreter: Rüger, Barthelt & Abel
(86) Internationale Anmeldenummer: PCT/EP2013/059268
(87) Internationale Veröffentlichungsnummer: WO 2013/185979

(56) Entgegenhaltungen:
- DE-A1-102010 017 153
- DE-U1-202006 011 956

## Beschreibung

Die Erfindung betrifft ein explosionsgeschütztes Gehäuse mit einer Durchführungsvorrichtung zum Durchführen eines Bauteils, insbesondere eines elektrischen Leiters, durch die Wandöffnung einer Wand des explosionsgeschützten Gehäuses. Das Gehäuse ist insbesondere in der Zündschutzart "druckfeste Kapselung" (Ex-d) ausgeführt.

Die Durchführung des Bauteils durch die Wandöffnung im Gehäuse muss zum einen den Vorschriften des Explosionsschutzes entsprechen. Hierfür ist in DE 299 03 103 U1 beispielsweise eine zünddurchschlagssichere Leitungseinführung vorgeschlagen. Die Leitungseinführung weist eine in die Wandöffnung des Gehäuses einschraubbare Metallhülse auf. Im Inneren der Einschraubhülse ist ein verschiebbar angeordneter Dichtring aus thermoplastischem Polyamidharz angeordnet. Durch diesen Dichtring soll sowohl eine Abdichtung nach radial außen zur Metallhülse, als auch nach radial Innen zum Kabelmantel hin erreicht werden. Auf die Einschraubhülse kann eine Überwurfmutter aufgeschraubt werden. Die Einschraubhülse weist zum Dichtring hin eine konische Innenfläche auf, die mit einer konischen Außenfläche des Dichtrings zusammenwirkt, um diesen radial nach innen auf den Kabelmantel hin zu klemmen.

DE 10 2010 017 153 A1 beschreibt eine Durchführungsvorrichtung zum Durchführen eines elektrischen Leiters durch die Wandöffnung einer Wand des explosionsgeschützten Gehäuses. Die Durchführungsvorrichtung hat einen Durchführungskörper, der über ein Außengewinde in die Wand eingeschraubt ist. Der Leiter erstreckt sich durch den Durchführungskörper hindurch. Über ein Gießharz wird der Bereich zwischen dem Leiter und dem Durchführungskörper verschlossen, wodurch eine nicht lösbare Verbindung entsteht.

Ausgehend hiervon soll eine verbesserte Durchführung geschaffen werden.

Diese Aufgabe wird mit einem explosionsgeschützten Gehäuse gemäß Patentanspruch 1 gelöst.

Das explosionsgeschützte Gehäuse weist eine Wandöffnung auf, durch die das Bauteil herausgeführt ist. Das Bauteil bzw. der elektrische Leiter ist insbesondere in seiner Erstreckungsrichtung starr, beispielsweise eine starre Schiene, die als elektrisch leitende Sammelschiene ausgeführt sein kann. Über die Sammelschiene kann ein elektrisches Potential aus dem Gehäuse heraus geführt und beispielsweise von einem explosionsgeschützten Gehäuse in ein benachbartes explosionsgeschütztes Gehäuse geführt werden. Beispielsweise kann die Sammelschiene geerdet sein.

In der Wandöffnung ist eine Durchführungsvorrichtung angeordnet, die dort einen zünddurchschlagsicheren Spalt bildet. Durch diesen Spalt ist das Bauteil in seiner Erstreckungsrichtung verschiebbar gegenüber dem Gehäuse angeordnet. Aufgrund von Temperaturschwankungen kann es zu Langenänderungen des Bauteils kommen. Wegen der Verschiebbarkeit des Bauteils gegenüber der die Wandöffnung aufweisenden Gehäusewand treten dort keine Belastungen des Bauteils und des Gehäuses auf. Die Durchführungsvorrichtung bildet einen zünddurchschlagsicheren Spalt, so dass die Relativbeweglichkeit des Bauteils gegenüber der Gehäusewand bei Gewährleistung des Explosionsschutzes erreicht ist.

Die Durchführungsvorrichtung ist am Bauteil befestigt und unter Bildung des zünddurchschlagsicheren Spalts gegenüber der Gehäusewand verschiebbar angeordnet.

Die Durchführungsvorrichtung weist bei einem Ausführungsbeispiel eine Klemmkörpereinheit auf, die das durch die Wandöffnung des Gehäuses verlaufende Bauteil umschließt. Die Klemmkörpereinheit ist vorzugsweise kraftund/oder formschlüssig mit dem durchgeführten Bauteil verbunden. Bei den üblicherweise in Erstreckungsrichtung des Bauteils auftretenden Kräften ist die Durchführungsvorrichtung gegenüber dem Bauteil unverschiebbar festgeklemmt.

Die Durchführungsvorrichtung kann außerdem eine die Klemmkörpereinheit mit einer radialen Klemmkraft beaufschlagende Hülse sowie eine mit der Hülse verschraubbare Kappe aufweisen. In Gebrauchslage der Durchführungsvorrichtung ist zwischen der Hülse und der Wandöffnung ein zünddurchschlagssicherer Spalt gebildet. Die Durchführungsvorrichtung ist nicht fest mit dem Gehäuse verbunden. Vorzugsweise ist die Durchführungsvorrichtung ausschließlich an dem durchgeführten Bauteil befestigt. Der Abschnitt der Hülse, der mit der Wandöffnung einen zünddurchschlagssicheren Spalt bildet, ist in Richtung der Längsachse so lang ausgeführt, dass die durch Temperaturschwankungen auftretenden Verschiebungen zwischen dem Bauteil und der Wand des Gehäuses stets einen ausreichend langen Spalt bilden, so dass die Zünddurchschlagssicherheit gewährleistet ist. Auf diese Weise können insbesondere starre Bauteile, wie etwa Strom- oder Sammelschienen, sehr einfach durch die Wandöffnung eines Gehäuses geführt und anschließend mit Hilfe der Durchführungsvörrichtung eine explosionsgeschützte Durchführung erreicht werden. Eine starre Sammelschiene lässt sich auch durch bzw. in mehrere Gehäuse durch- bzw. hineinführen.

Diese Anordnung aus Gehäuse und Durchführungsvorrichtung kann durch die erläuterte Ausgestaltung der Durchführungsvorrichtung besonders einfach hergestellt werden. Die Klemmkörpereinheit der Durchführungsvorrichtung ist vorzugsweise elastisch verformbar. Bei den üblicherweise auftretenden Kräften, denen die Durchführungsvorrichtung ausgesetzt ist, findet aber keine plastische Verformung der Klemmkörpereinheit statt. Die Klemmkörpereinheit weist einen sich entlang einer Längsachse erstreckenden Kanal zur Aufnahme eines Längsabschnitts des durch die Wandöffnung durchgeführten Bauteils auf. Vorzugsweise liegt die Klemmkörpereinheit an dem gesamten Längsabschnitt form- und kraftschlüssig an. Die Klemmkörpereinheit hat außerdem eine vorzugsweise koaxial um die Längsachse herum verlaufende konische Klemmfläche. Eine konische Innenfläche der Hülse ist an die Konizität der Klemmfläche angepasst. Durch eine Verschiebung der Hülse in Längsrichtung kann dadurch eine radiale Klemmkraft auf die Klemmkörpereinheit ausgeübt werden, wodurch sich diese elastisch verformt und wiederum eine Klemmverbindung mit dem im Kanal verlaufenden Längsabschnitt des Bauteils herstellt.

Die konische Klemmfläche und die konische Innenfläche können jeweils eine ringförmig um die Längsachse geschlossene, zusammenhängende Fläche bilden. Es ist abweichend hiervon auch möglich, dass die Klemmfläche und/oder die Innenfläche in mehrere Flächenabschnitte unterteilt ist, die durch Ausnehmungen, Nuten oder ähnlichem unterbrochen oder getrennt sind. Solche Flächenabschnitte können in Umfangsrichtung um die Längsachse verteilt angeordnet sein.

Zur axialen Verschiebung der Hülse dient eine mit der Hülse verschraubbare Kappe. An der Kappe ist eine Drückfläche vorhanden, die rechtwinkelig oder schräg gegenüber der Längsachse verlaufen kann. An der Drückfläche stützt sich ein Drückring ab. Auf der der Drückfläche entgegengesetzten Seite des Drückrings weist die Klemmkörpereinheit eine erste Axialfläche auf, die rechtwinkelig oder schräg gegenüber der Längsachse verlaufen ist. Über den Drückring kann somit zwischen der Drückfläche zwischen der Kappe und der ersten Axialfläche eine Axialkraft übertragen werden. Über die Schraubverbindung der Kappe mit der Hülse wird diese Axialkraft zwischen der konischen Innenfläche der Hülse und der Klemmfläche abgestützt und bewirkt mithin die radiale Klemmkraft

Über den Drückring können mithin Axialkräfte zwischen der Klemmkörpereinheit und der Kappe übertragen werden. Außerdem bietet der Drückring die Möglichkeit, das Übertragen von Kräften in Umfangsrichtung um die Längsachse zwischen der Kappe und der elastisch verformbaren Klemmkörpereinheit zu verhindern. Dadurch kann gewährleistet werden, dass sich die Klemmkörpereinheit beim Herstellen der Schraubverbindung zwischen der Hülse und der Kappe in Umfangsrichtung nicht verformt, beispielsweise tordiert. Dadurch ist wiederum erreicht, dass Verformungen in Umfangsrichtung von der Durchführungsvorrichtung nicht auf das durchgeführte Bauteil übertragen werden.

Die Durchführungsvorrichtung lässt sich einfach montieren. Gleichzeitig ist eine gute Klemmverbindung gegenüber dem Bauteil erreicht. An einem Abschnitt der Außenfläche der Hülse kann gegenüber der Wand des Gehäuses oder eines in der Wandöffnung angeordneten Zwischenstücks ein zünddurchschlagssicherer Spalt gebildet werden. Hierfür weist die Hülse insbesondere einen Endabschnitt mit zylindrischer Außenfläche auf.

Vorzugsweise ist der Drückring sozusagen als Gleitring ausgeführt. Der Drückring kann gegenüber der ersten Axialfläche und/oder gegenüber der Drückfläche der Kappe ein Gleitlager bilden. Wenn sich der Drückring gleitend an der ersten Axialfläche und/oder der Drückfläche abstützt, kann er keine bzw. lediglich vernachlässigbar kleine Kräfte und Momente in Umfangsrichtung um die Längsachse übertragen.

Vorzugsweise ist zwischen der Hülse und dem Drückring ein Zwischenraum vorhanden. Dieser Zwischenraum kann in Richtung der Längsachse gesehen abhängig von der gewünschten Klemmkraft unterschiedlich groß sein. Je stärker der Drückring in Richtung der Längsachse zwischen der Kappe und der Klemmkörpereinheit eingeklemmt wird, desto größer ist auch die über die Klemmkörpereinheit auf den Längsabschnitt des Bauteils im Kanal ausgeübte radiale Klemmkraft.

Die Klemmkörpereinheit weist vorzugsweise zwei Klemmkörper auf, die jeweils eine Anlagefläche aufweisen, an denen die beiden Klemmkörper aneinander anliegen. In montierter Gebrauchslage der Durchführungsvorrichtung werden die beiden Klemmkörper durch die auf die Klemmfläche aufgesteckte Hülse mit ihren Anlageflächen gegeneinander gedrückt. Die beiden Klemmkörper selbst liegen lose aneinander. Vorzugsweise weist jeder Klemmkörper einen Umfangsabschnitt des Kanals auf. Die Trennstelle der Klemmkörpereinheit zwischen den beiden Klemmkörpern verläuft somit durch den Kanal entlang dessen gesamter Längserstreckung. Die beiden Klemmkörper können dadurch an der gewünschten Stelle von entgegengesetzten Seiten an den aufzunehmenden Längsabschnitt des Bauteils angesetzt und positioniert werden. Eine Relativverschiebung der Klemmkörpereinrichtung gegenüber dem Bauteil ist bei der Montage daher nicht notwendig. Trotz hoher Klemmkräfte zwischen der Klemmkörpereinheit und dem Bauteil kann diese dennoch problemlos ohne die Gefahr von Beschädigungen an der gewünschten Stelle des Bauteils befestigt werden.

Bei einem Ausführungsbeispiel sind die Anlageflächen der Klemmkörper als ebene Flächen ausgeführt. Vorzugsweise liegen die beiden Klemmkörper mit ihren Anlageflächen in einer Ebene aneinander an, die durch den Kanal in der gesamten Längsrichtung verläuft, wobei die Längsachse insbesondere in dieser Ebene angeordnet ist.

Der Querschnitt des Kanals ist insbesondere an den Querschnitt des aufzunehmenden Bauteils angepasst. Diese Anpassung trifft insbesondere die Form und die Größe des Querschnitts. Der Querschnitt des Kanals und des Längsabschnitts des Bauteils ist bei einem Ausführungsbeispiel rechteckig.

An der Klemmkörpereinheit kann eine zweite Axialfläche vorhanden sein. Die Normalenvektoren der ersten Axialfläche und der zweiten Axialfläche weisen voneinander weg, vorzugsweise in entgegengesetzte Richtungen parallel zur Längsachse. Die Klemmfläche der Klemmkörpereinheit kann dabei ein Richtung der Längsachse gesehen zwischen den beiden Axialflächen angeordnet sein.

Die Hülse kann einen radial nach innen weg ragenden Ringflansch aufweisen, der der zweiten Axialfläche der Klemmkörpereinheit zugeordnet ist. Über diesen Ringflansch kann eine Axialverschiebung in Richtung der Längsachse zwischen der Hülse und der Klemmkörpereinheit begrenzt werden. Auf diese Weise lässt sich auch die Klemmkraft zwischen der Klemmkörpereinheit und dem im Kanal aufgenommenen Längsabschnitt des Bauteils begrenzen.

Vorteilhafte Ausführungen der Erfindung ergeben sich aus den abhängigen Patentansprüchen und der Beschreibung. Die Beschreibung beschränkt sich auf wesentliche Merkmale der Erfindung. Die Zeichnung ist ergänzend heranzuziehen. Nachfolgend werden Ausführungsformen der Erfindung anhand der beigefügten Zeichnung näher erläutert.

Es zeigen:
Figur 1 eine schematische, blockschaltbildähnliche Darstellung einer mehrere Gehäuse verbindenden Sammelschiene mit im Bereich der Wandöffnungen der gehäuseangeordneten Durchführungsvorrichtungen,
Figur 2 einen Drückring der Durchführungsvorrichtung in perspektivischer Darstellung,
Figur 3 eine Kappe der Durchführungsvorrichtung in perspektivischer Darstellung,
Figur 4 die Kappe nach Figur 3 im Längsschnitt,
Figur 5 eine Hülse der Durchführungsvorrichtung in perspektivischer Darstellung,
Figur 6 die Hülse nach Figur 5 im Längsschnitt,
Figur 7 eine Explosionsdarstellung eines Ausführungsbeispiels der Durchführungsvorrichtung in perspektivischer Ansicht und
Figuren 8 und 9 jeweils einen Längsschnitt durch die Durchführungsvorrichtung nach Figur 7 in montiertem Zustand.

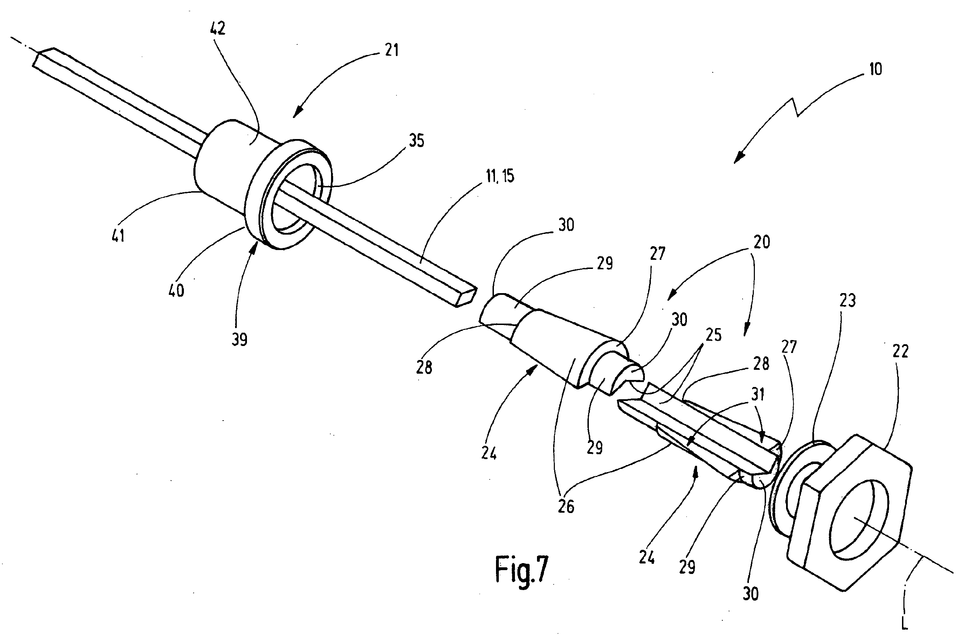

In den Figuren 7 bis 9 ist ein Ausführungsbeispiel einer Durchführungsvorrichtung 10 veranschaulicht. Die Durchführungsvorrichtung 10 dient dazu, ein Bauteil und beispielsgemäß ein starres, sich axial entlang einer Längsachse L erstreckendes Bauteil 11 durch die Wandöffnung 12 einer Wand 13 eines Gehäuses 14 explosionsgeschützt hindurchzuführen. Bei dem Bauteil 11 handelt es sich beispielsgemäß um eine geerdete Sammelschiene 15. Im Folgenden wird beispielhaft als Bauteil die Sammelschiene 15 erwähnt, wobei die in diesem Zusammenhang erläuterten Merkmale auch für andere insbesondere in ihrer Erstreckungsrichtung starre Bauteile gelten. Alternativ zu diesem Ausführungsbeispiel kann die Durchführungsvorrichtung 10 auch zur Durchführung von flexiblen Bauteilen, beispielsweise elektrischen Kabeln verwendet werden.

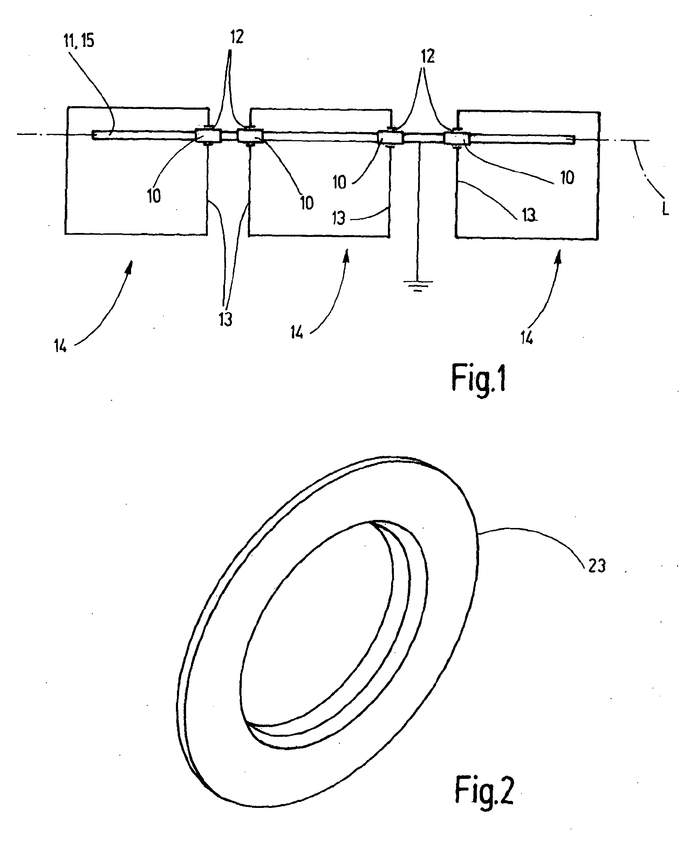

Bei der in Figur 1 sehr stark schematisierten Darstellung ist in jeder Wandöffnung 12 jeweils eine Durchführungsvorrichtung 10 angeordnet. Bei ausreichend kleinem Abstand zweier benachbarter Gehäuse 14 kann auch eine gemeinsame Durchführungsvorrichtung 10 zur explosionsgeschützten Durchführung der Sammelschiene 15 durch die beiden benachbarten Bandöffnungen 12 verwendet werden.

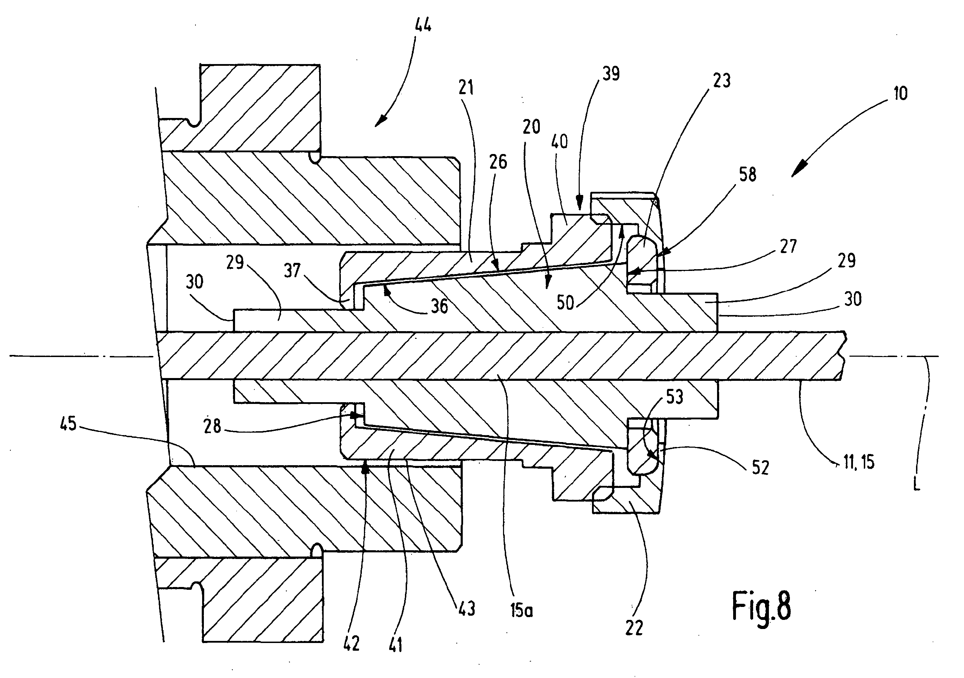

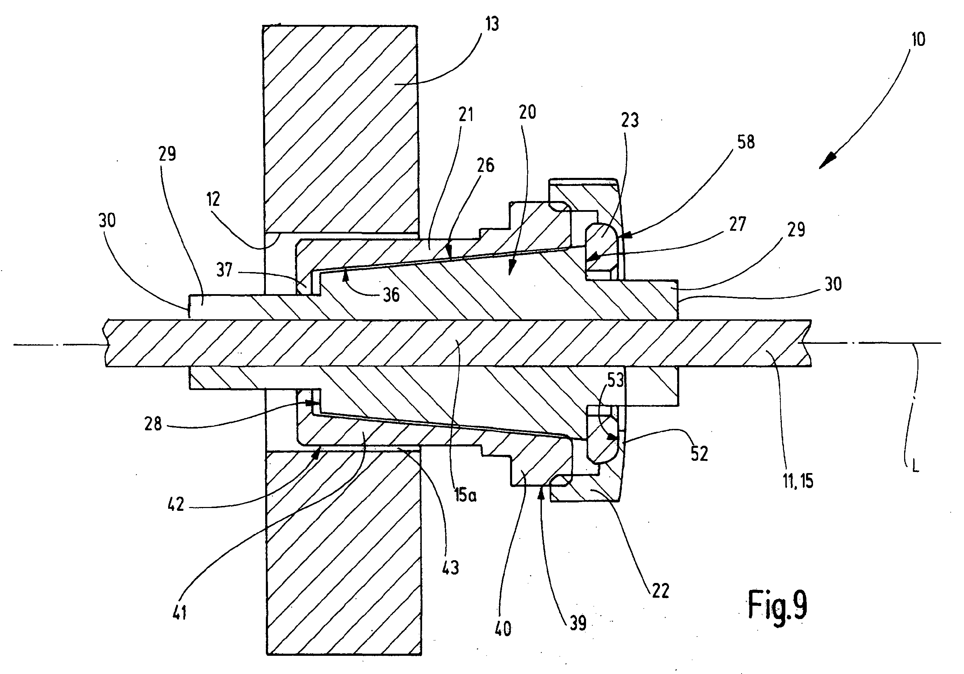

Die Sammelschiene 15 ist in ihrer Erstreckungsrichtung, entlang einer Längsachse L. relativ zu der Wand 13 mit der Wandöffnung 12 verschiebbar gelagert. In der Wandöffnung 12 bildet die Durchführungsvorrichtung 10 einen die Längsverschiebbarkeit ermöglichenden zünddurchschlagsicheren Spalt 43 (Figuren 8, 9). Die Durchführungsvorrichtung 10 kann dafür bei einem nicht dargestellten Ausführungsbeispiel mit der Wand 13 verbunden sein, wobei der Spalt 43 dann zwischen der Durchführungsvorrichtung 10 und der Sammelschiene 15 gebildet ist. Beim dem beschriebenen bevorzugten Ausführungsbeispiel sitzt die Durchführungsvorrichtung 10 unverschiebbar an der Sammelschiene 15 und bildet gegenüber der Wand 13 in der Wandöffnung 12 einen zünddurchschlagsicheren Spalt 43, vorzugsweise einen ringsumlaufenden Ringspalt.

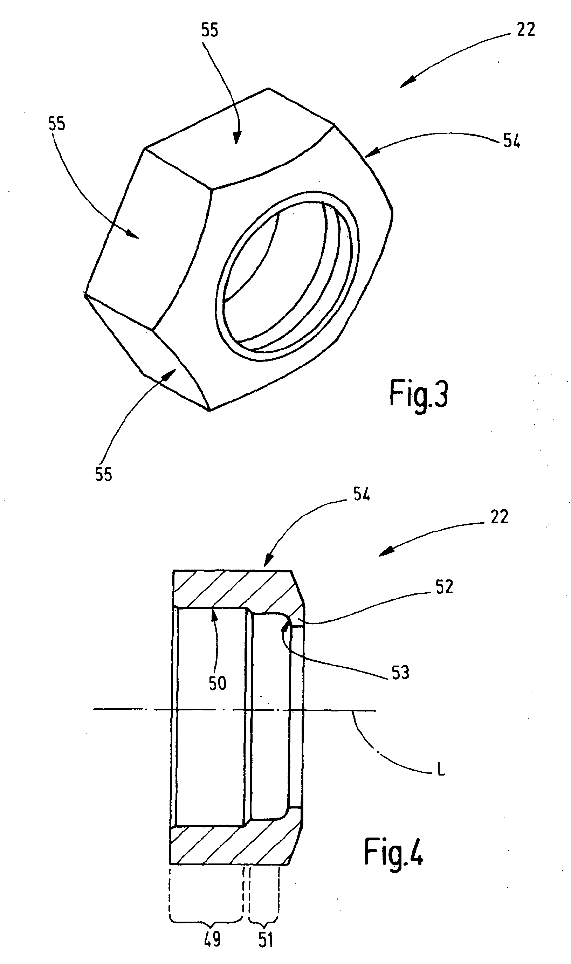

Ein Ausführungsbeispiel einer erfindungsgemäßen Durchführungsvorrichtung 10 wird nachfolgend anhand der Figuren 2 bis 9 erläutert.

Die Durchführungsvorrichtung 10 weist eine Klemmkörpereinheit 20, eine Hülse 21, eine Kappe 22 sowie einen Drückring 23 auf. Vorzugsweise sind keine weiteren Bauteile vorhanden. Bei dem hier beschriebenen Ausführungsbeispiel ist die Klemmkörpereinrichtung 20 durch zwei Klemmkörper 24 gebildet. Die Klemmkörpereinrichtung 20 ist sozusagen in zwei Teile und in Umfangsrichtung um die Längsachse L gesehen vorzugsweise in zwei Hälften aufgeteilt.

Entlang der Längsachse L erstreckt sich durch die Klemmkörpereinheit 20 ein Kanal 25 zur Aufnahme eines Längsabschnitts 15a der Sammelschiene 15. Der Querschnitt des Kanals 25 ist an dem Querschnitt des Bauteils 11 angepasst. Bei dem hier beschriebenen Ausführungsbeispiel ist die Querschnittsform der Sammelschiene 15 und mithin des Kanals 25 rechteckförmig. Der Querschnitt des Kanals 25 ist entlang der gesamten Klemmkörpereinheit 20 konstant.

Die Klemmkörpereinheit 20 weist eine sich in Richtung der Längsachse L konisch verjüngende Klemmfläche 26 auf. Die Klemmfläche 26 entspricht der Mantelfläche eines Kegelstumpfs. An die Klemmfläche 26 schließt sich axial in Richtung der Längsachse L betrachtet auf der einen Seite eine erste ringförmige Axialfläche 27 und auf der anderen Seite eine zweite ringförmige Axialfläche 28 an. Die beiden Axialflächen 27, 28 verlaufen beim Ausführungsbeispiel in einer Ebene radial zur Längsachse L. Die Normalenvektoren der beiden Axialflächen 27, 28 weisen parallel zur Längsachse L in entgegengesetzte Richtungen.

Die Klemmkörpereinheit 20 weist zwei zylindrische Axialfortsätze 29 auf, die jeweils ein axiales Ende 30 der Klemmkörpereinheit 20 bilden. Die Axialflächen 27, 28 bilden sozusagen Ringschultern oder Ringstufen zwischen der Klemmfläche 26 und dem jeweils benachbarten Axialfortsatz 29 der Klemmkörpereinheit 20. Im Bereich der ersten Axialfläche 27 weist die Klemmkörpereinheit 20 ihren größten Außendurchmesser auf. Ausgehend von der ersten Axialfläche 27 verjüngt sich die Klemmkörpereinheit 20 entlang der Klemmfläche 26 zur zweiten Axialfläche 28 hin.

Wie erwähnt, besteht die Klemmkörpereinheit 20 aus zwei separaten Klemmkörpern 24. Die Klemmkörper 24 weisen jeweils einen Umfangsabschnitt der Klemmkörpereinheit 20 auf. Die Klemmkörpereinheit 20 ist beispielsgemäß entlang einer Ebene, in der die Längsachse L verläuft, in die zwei Klemmkörper 24 unterteilt. Somit ist auch der Kanal 25 entlang seiner gesamten Längserstreckung auf die beiden Klemmkörper 24 aufgeteilt. Durch diese Maßnahme kann die Klemmkörpereinheit 20 bei montierter Sammelschiene 15 von entgegengesetzten Seiten her an der gewünschten Anbringungsstelle auf die Sammelschiene 15 aufgesetzt werden, so dass die Klemmkörpereinheit 20 die Sammelschiene 15 vollständig umschließt und den Längsabschnitt 15a der Sammelschiene 15 im Kanal 25 aufnimmt.

Die beiden Klemmkörper 24 weisen jeweils eine Anlagefläche 31 auf. In montierter Lage liegen die beiden Klemmkörper 24 mit ihrer jeweiligen Anlagefläche 31 aneinander an. Die Anlagefläche 31 jedes Klemmkörpers 24 ist in zwei Abschnitte unterteilt, die durch den am jeweiligen Klemmkörper 24 vorhandenen Kanalabschnitt des Kanals 25 voneinander getrennt sind. Beim Ausführungsbeispiel sind die Abschnitte der Anlagefläche 31 in dem Bereich zwischen den beiden Axialflächen 27, 28 gebildet.

Die beiden Klemmkörper 24 sind in montiertem Zustand lose mit ihren Anlageflächen 31 aneinander gelegt und werden durch die Hülse 21 gegeneinander gedrückt. Die Hülse 21 ist dazu eingerichtet, eine radiale Klemmkraft auf die Klemmfläche 26 der Klemmkörpereinheit 20 auszuüben. Die Klemmkörpereinheit 20 bzw. die beiden Klemmkörper 24 sind aus einem Material hergestellt, das sich durch die von der Hülse 21 erzeugten radialen Kräfte elastisch verformen kann. Dabei wird ein Material gewählt, das bei den üblicherweise auftretenden Temperaturen, denen die Durchführungsvorrichtung 10 ausgesetzt ist, keine plastischen Verformungen aufweisen. Das Material weist keine Kaltfließfähigkeit auf.

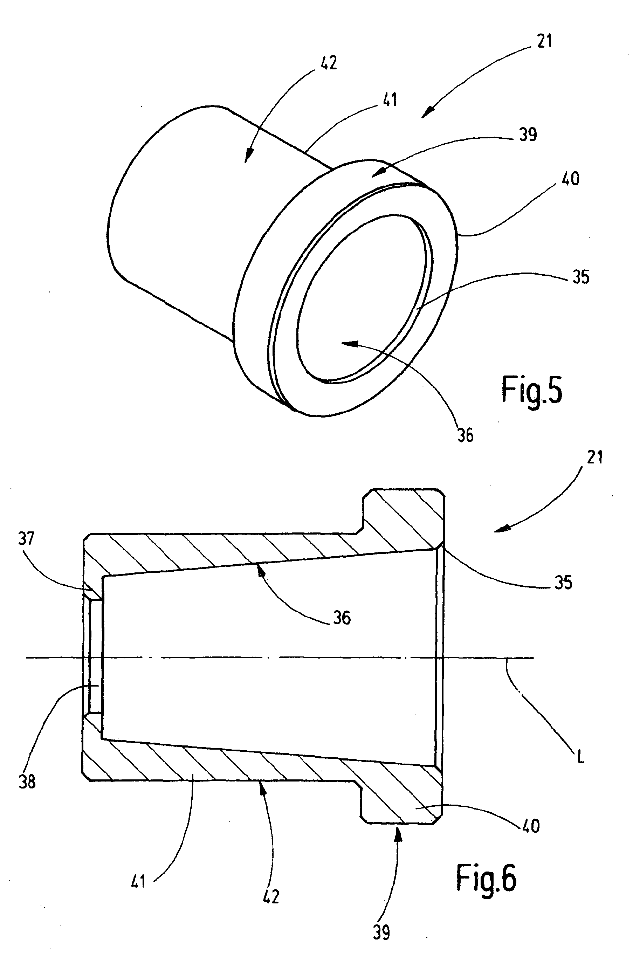

Die Hülse 21 ist in den Figuren 5 und 6 im Detail dargestellt. Sie weist eine sich ausgehend von einer axialen Aufstecköffnung 35 in Richtung der Längsachse L konisch verjüngende Innenfläche 36 auf. Auf der der Aufstecköffnung 35 entgegengesetzten Axialseite ragt radial nach innen von der Innenfläche 36 ein Radialflansch 37 weg. Der Radialflansch 37 umschließt eine Endöffnung 38 der Hülse 21, deren Durchmesser zumindest dem Außendurchmesser des Axialfortsatzes 29 entspricht, der sich an die zweite Axialfläche 28 anschließt.

Die Konizität der Innenfläche 36 ist an die Konizität der Klemmfläche 26 angepasst. Beim Aufstecken der Hülse 21 über die Klemmkörpereinheit 20 wird daher eine flächige Anlage zwischen der Innenfläche 36 und der Klemmfläche 26 erzeugt, die jedoch nicht die gesamte Klemmfläche 26 und/oder die gesamte Innenfläche 36 abdecken muss. In montiertem Zustand kann zwischen dem Radialflansch 37 und der zweiten Axialfläche 28 ein Abstand verbleiben. Dadurch wir sichergestellt, dass die Klemmkörpereinheit 20 zum Radialflansch 37 hin beim Aufschrauben der Kappe 22 relativ zur Hülse 21 verschiebbar ist. Gelangt der Radialflansch 37 mit der zweiten Axialfläche 28 bzw. der Klemmkörpereinheit 20 zur Anlage, so wird eine weitere Relativverschiebung zwischen der Klemmkörpereinheit 20 und der Hülse 21 in Längsrichtung unterbunden. Die Klemmkraft kann auf diese Weise begrenzt werden.

An der Aufstecköffnung 35 weist die Hülse 21 den größten Innendurchmesser auf. Im Bereich der Aufstecköffnung 35 und beispielsgemäß unmittelbar im Anschluss daran ist am Außenumfang der Hülse 21 ein Außengewinde 39 vorhanden. Das Außengewinde 39 ist beim Ausführungsbeispiel an der äußeren Ringfläche eines Ringabschnitts 40 vorgesehen. Am Ringabschnitt 40 weist die Hülse 21 den größten Außendurchmesser auf.

Im Anschluss an den Ringabschnitt 40 schließt sich ein zylindrischer Endabschnitt 41 der Hülse 21 an, der eine zylindrische Außenfläche 42 aufweist. Die zylindrische Außenfläche 42 des Endabschnitts 41 dient vorzugsweise zur Bildung eines zünddurchschlagssicheren Spalts 43 im Bereich der Wandöffnung 12. Dieser durchschlagssichere Spalt 43 kann beispielsweise unmittelbar zwischen der zylindrischen Außenfläche 42 und der die Wandöffnung 12 begrenzenden Wandfläche gebildet sein. Alternativ hierzu besteht auch die Möglichkeit, den zünddurchschlagssicheren Spalt 43 zwischen der zylindrischen Außenfläche 42 und einer Baueinheit 44 auszubilden, die mit der Wand 13 des Gehäuses 14 im Bereich der Wandöffnung 12 verbunden ist. Die Baueinheit 44 kann hierzu eine zylindrische Öffnung 45 aufweisen, die mit der Durchführungsvorrichtung 10 zusammenarbeitet, wie dies schematisch in Figur 8 veranschaulicht ist. Die Baueinheit 44 kann beispielsweise eine zylindrische Öffnung 45 bereitstellen, deren Länge in Richtung der Längsachse L größer ist als die der Wandöffnung 12.

Die Kappe 22 der Durchführungsvorrichtung 10 ist dazu vorgesehen, auf das Außengewinde 39 der Hülse 21 aufgeschraubt zu werden. Hierfür weist die Kappe 22 einen ersten hohlzylindrischen Abschnitt 49 mit einem Innengewinde 50 auf. An den ersten hohlzylindrischen Abschnitt 49 schließt sich ein zweiter hohlzylindrischer Abschnitt 51 an, der einen geringeren Innendurchmesser aufweist. Beide hohlzylindrischen Abschnitte 49, 51 sind koaxial zur Längsachse L angeordnet. Auf der dem ersten hohlzylindrischen Abschnitt 49 entgegengesetzten Seite des zweiten hohlzylindrischen Abschnitts 51 ist eine radial nach innen ragende Schulter 52 vorhanden. An der Schulter 52 ist auf der dem zweiten hohlzylindrischen Abschnitt 51 zugewandten Seite eine Drückerfläche 53 vorhanden, die in einer Ebene radial zur Längsachse L oder einer schräg zur Längsachse L verlaufenden Ebene angeordnet sein kann.

Die Außenseite 54 der Hülse 22 ist derart ausgeführt, dass sie zum Ansetzen eines handelsüblichen Werkzeugs geeignet ist. Beim Ausführungsbeispiel sind an der Außenseite 54 in Umfangsrichtung regelmäßig sechs ebene Flächenbereiche 55 gebildet, an denen ein Werkzeug, beispielsgemäß ein Gabelschlüssel oder dergleichen zum Herstellen der Schraubverbindung mit der Hülse 21 angesetzt werden kann.

Zwischen der Kappe 22 und der Klemmkörpereinheit 20 ist der Drückring 23 angeordnet. Beim Ausführungsbeispiel ist der Drückring 23 zumindest teilweise im zweiten hohlzylindrischen Abschnitt 51 der Kappe 22 aufgenommen. Der Drückring 23 kann in Längsrichtung gemessen auch etwas größer sein als die Länge des zweiten hohlzylindrischen Abschnitts 51, so dass er etwas in den ersten hohlzylindrischen Abschnitt 49 hineinragt. Der Außendurchmesser des Drückrings 23 ist an den Innendurchmesser des zweiten hohlzylindrischen Abschnitts 51 angepasst. Der Drückring 23 ist daher nicht in Kontakt mit dem Innengewinde 50 des einen größeren Innendurchmesser aufeisenden ersten hohlzylindrischen Abschnitts 49 der Kappe 22.

In montiertem Zustand stützt sich der Drückring 23 an der Drückfläche 53 der Hülse 21 ab. Auf seiner axial entgegengesetzten Seite liegt der Drückring 23 an der ersten Axialfläche 27 der Klemmkörpereinheit 20 an. Der Drückring 23 umschließt dabei den sich an die ersten Axialfläche 27 anschließenden Axialfortsatz 29 der Klemmkörpereinheit 20 koaxial. Der Drückring 23 dient dazu, zwischen der Kappe 22 und der Klemmkörpereinheit 20 eine Axialkraft zu übertragen. Gleichzeitig bildet er ein Gleitlager 58 beispielsgemäß mit der Hülse 21 im zweiten hohlzylindrischen Abschnitt 51. Dadurch verhindert der Drückring 23 beim Aufschrauben der Kappe 22 auf die Hülse 21 die Übertragung einer Kraft bzw. eines Moments um die Längsachse L auf die Klemmkörpereinheit 20. Torsionen der Klemmkörpereinheit 20 und mithin auch. der Sammelschiene 15 sind dadurch verhindert. Alternativ oder zusätzlich könnte ein solches Gleitlager auch zwischen dem Drückring 23 und der Klemmkörpereinheit 20 vorgesehen sein.

Die Durchführungsvorrichtung 10 wird wie folgt montiert:

Zunächst wird die Sammelschiene 15 durch eine Wandöffnung 12 einer Wand 13 eines Gehäuses 14 hindurchgeführt und im Gehäuse oder am Gehäuse 14 befestigt. Die Sammelschiene 15 kann dabei wie in Figur 1 veranschaulicht auch durch mehrere Wandöffnungen 12 unterschiedlicher Gehäuse 14 hindurch verlaufen. Die Hülse 21, der Drückring 23 und die Kappe 22 werden von einem Ende her auf die Sammelschiene 15 aufgesteckt. Sowohl die Hülse 21, als auch der Drückring 23 und die Kappe 22 weisen einen größeren Innenquerschnitt auf, als die Sammelschiene 15, so dass sie kraftfrei entlang der Sammelschiene 15 zur Anbringungsstelle bewegt werden können.

An der gewünschten Anbringungsstelle werden die beiden Klemmkörper 24 der Klemmkörpereinheit 20 von entgegengesetzten Seiten um den Längsabschnitt 15a der Sammelschiene 15 herum angeordnet und mit den Anlageflächen 31 aneinandergelegt. Im Anschluss daran wird von der einen Seite die Hülse 21 und von der anderen Seite der Drückring 23 und die Kappe 22 auf die Klemmkörpereinheit 20 axial entlang der Längsachse L aufgeschoben. Die Innenfläche 36 der Hülse 21 gelangt dabei zu Anlage mit der Klemmfläche 26. Der Drückring 23 liegt einerseits an der ersten Axialfläche 27 und andererseits an der Drückfläche 53 an. Zwischen dem Drückring 23 und der Hülse 21 ist in Längsrichtung ein Zwischenraum oder Abstand vorhanden. Der erste hohlzylindrische Abschnitt 49 mit dem Innengewinde 50 wird auf das Außengewinde 39 der Hülse 21 aufgeschraubt. Dabei überträgt der Drückring 23 eine Axialkraft in Richtung der Längsachse zwischen der Kappe 22 und der Hülse 21. Durch die Axialkraft erzeugt die Hülse 21 über die gegenüber der Längsachse L schräg verlaufende Innenfläche 36 eine Klemmkraft auf die Klemmkörpereinheit 20. Die Klemmkörpereinheit 20 verformt sich elastisch und schmiegt sich an den Längsabschnitt 15a der Sammelschiene 15 an. Dadurch entsteht zwischen der Durchführungsvorrichtung 10 und dem Bauteil 11 bzw. der Sammelschiene 15 eine form- und kraftschlüssige Klemmverbindung.

Eine Verbindung zwischen der Durchführungsvorrichtung 10 und dem Gehäuse 14 wird nicht hergestellt. Die Durchführungsvorrichtung 10 ist entlang der Längsachse L relativ zum Gehäuse 14 bzw. der zwischen der Durchführungsvorrichtung 10 und dem Gehäuse 14 angeordneten Baueinheit 44 beweglich oder verschiebbar gelagert. Auf diese Weise können temperaturbedingte Verschiebungen zwischen der Sammelschiene 15 und dem Gehäuse 14 oder einer mit dem Gehäuse 14 verbundenen Baueinheit 44 ausgeglichen werden.

Wie in Figur 9 veranschaulicht, kann die Durchführungsvorrichtung 10 unmittelbar in einer Wandöffnung 12 der Wand 13 eines Gehäuses 14 angeordnet sein. Vorzugsweise dient dann der zylindrische Endabschnitt 41 mit seiner zylindrischen Außenfläche 42 zur Bildung eines zünddurchschlagssicheren Spaltes 43 zwischen der zylindrischen Außenfläche 42 und dem die Wandöffnung 12 begrenzenden Abschnitts der Wand 13. Entsprechend könnte ein solcher zünddurchschlagssicherer Spalt 43 auch zwischen einer zylindrischen Öffnung 45 einer mit der Wand 13 des Gehäuses 14 verbundenen Baueinheit 44 und der Außenfläche 42 des zylindrischen Endabschnitts 41 der Hülse 21 gebildet werden (Figur 8).

Die Erfindung betrifft eine Durchführungsvorrichtung 10 für ein explosionsgeschütztes Gehäuse 14, das insbesondere in der Zündschutzart "druckfeste Kapselung" ausgeführt ist. In einer Wandöffnung 12 des Gehäuses 14 ist die Durchführungsvorrichtung 10 angeordnet und bildet dort einen zünddurchschlagsicheren Spalt 43. Durch diesen Spalt 43 ist ein starres Bauteil 11 in seiner Erstreckungsrichtung verschiebbar gegenüber der Wand 13 des Gehäuses 14 angeordnet. Die Durchführungsvorrichtung 10 weist insbesondere eine Klemmkörpereinheit 20, eine Hülse 21, eine Kappe 22 und einen Drückring 23 auf. Die Hülse 21 und die Kappe 22 können miteinander verschraubt werden. Über den Drückring 23 werden Axialkräfte zwischen der Klemmkörpereinheit 20 und der Kappe 22 übertragen, die wiederum an schräg zur Längsachse L verlaufenden, aneinander anliegenden Flächen 26, 36 der Klemmkörpereinheit 20 bzw. der Hülse 21 abgestützt werden. Dadurch erzeugt die Hülse 21 eine radiale Klemmkraft auf die Klemmkörpereinheit 20. Die Klemmkörpereinheit 20 wird entlang einer Längsachse L vollständig von einem Kanal 25 durchsetzt, in dem ein Längsabschnitt eines Bauteils 11, vorzugsweise eines elektrischen Leiters, angeordnet ist. Aufgrund der Klemmkraft durch die Hülse 21 wird die Klemmkörpereinheit 20 elastisch verformt und klemmt die Durchführungsvorrichtung 10 am Längsabschnitt 15a des Bauteils 11, 15 fest. Auf diese Weise kann die Durchführungsvorrichtung 10 verschiebungssicher am Bauteil 11, 15 und gleichzeitig relativ zum Gehäuse 14 verschiebbar gelagert werden.

### Bezugszeichenliste:

- 10: Durchführungsvorrichtung
- 11: Bauteil
- 12: Wandöffnung
- 13: Wand
- 14: Gehäuse
- 15: Sammelschiene
- 15a: Längsabschnitt

- 20: Klemmkörpereinheit
- 21: Hülse
- 22: Kappe
- 23: Drückring
- 24: Klemmkörper
- 25: Kanal
- 26: Klemmfläche
- 27: erste Axialfläche
- 28: zweite Axialfläche
- 29: Axialfortsatz
- 30: axiales Ende der Klemmkörpereinheit
- 31: Anlagefläche

- 35: Aufstecköffnung
- 36: Innenfläche
- 37: Radialflansch
- 38: Endöffnung
- 39: Außengewinde
- 40: Ringabschnitt
- 41: zylindrischer Endabschnitt
- 42: zylindrische Außenfläche
- 43: zünddurchschlagsicherer Spalt
- 44: Baueinheit
- 45: zylindrische Öffnung
- 49: erster hohlzylindrischer Abschnitt
- 50: Innengewinde
- 51: zweiter hohlzylindrischer Abschnitt
- 52: Schulter
- 53: Drückfläche
- 54: Außenseite
- 55: Flächenbereich

- 58: Gleitlager

- L: Längsachse

## Patentansprüche

1. Explosionsgeschütztes Gehäuse (14) mit einer Wand (13), in der eine Wandöffnung (12) vorhanden ist, durch die ein in seiner Erstreckungsrichtung starres Bauteil (11, 15) aus dem Inneren des Gehäuses (14) nach außen geführt ist,
mit einer in der Wandöffnung (12) angeordneten Durchführungsvorrichtung (10), die gegenüber dem Gehäuse (14) oder dem Bauteil verschiebbar gelagert ist,
wobei zwischen der Durchführungsvorrichtung (10) und der Wandöffnung (12) oder dem Bauteil (11, 15) ein zünddurchschlagsicherer Spalt (43) gebildet ist,
und wobei die Durchführungsvorrichtung (10) unverschiebbar mit dem Bauteil (11, 15) verbunden und gegenüber dem Gehäuse verschiebbar angeordnet ist.

2. Explosionsgeschütztes Gehäuse nach Anspruch 1,
**dadurch gekennzeichnet, dass** die Durchführungsvorrichtung (10) eine das Bauteil (11, 15) umschließende Klemmkörpereinheit (20), eine die Klemmkörpereinheit (20) mit einer radialen Klemmkraft beaufschlagende Hülse (21) und eine mit der Hülse verschraubbare Kappe (22) aufweist.

3. Explosionsgeschütztes Gehäuse nach Anspruch 1 oder 2,
**dadurch gekennzeichnet, dass** es in der Zündschutzart "druckfeste Kapselung" ausgeführt ist.

4. Explosionsgeschütztes Gehäuse nach einem der Ansprüche 1 bis 3,
**dadurch gekennzeichnet, dass** die Durchführungsvorrichtung (10) aufweist:
- eine Klemmkörpereinheit (20), die einen sich entlang einer Längsachse (L) erstreckenden Kanal (25) zur Aufnahme eines Längsabschnitts (15a) des Bauteils (11, 15) aufweist und die eine um die Längsachse (L) herum verlaufende konische Klemmfläche (26) aufweist,
- eine Hülse (21), die eine konische Innenfläche (36) aufweist, deren Konizität an die der Klemmfläche (26) der Klemmkörpereinheit (20) angepasst ist,
- eine Kappe (22), die mit der Hülse (21) verschraubbar ist und die eine Drückfläche (53) aufweist,
- einen Drückring (23), der zwischen der Drückfläche (53) der Kappe (22) und einer ersten Axialfläche (27) der Klemmkörpereinheit (20) angeordnet und dazu eingerichtet ist, Axialkräfte zwischen der Drückfläche (52) und der ersten Axialfläche (27) zu übertragen.

5. Explosionsgeschütztes Gehäuse nach Anspruch 4,
**dadurch gekennzeichnet, dass** die Drückfläche (53) und/oder die erste Axialfläche (27) schräg oder rechtwinkelig zur Längsachse (L) ausgerichtet sind.

6. Explosionsgeschütztes Gehäuse nach Anspruch 4 oder 5,
**dadurch gekennzeichnet, dass** zwischen dem Drückring (23) einerseits und der Drückfläche (53) und/oder der ersten Axialfläche (27) andererseits ein Gleitlager (58) gebildet ist.

7. Explosionsgeschütztes Gehäuse nach einem der Ansprüche 4 bis 6,
**dadurch gekennzeichnet, dass** zwischen der Hülse (21) und dem Drückring (23) ein Zwischenraum vorhanden ist.

8. Explosionsgeschütztes Gehäuse nach einem der Ansprüche 4 bis 7,
**dadurch gekennzeichnet, dass** die Klemmkörpereinheit (20) zwei Klemmkörper (24) aufweist, die jeweils eine Anlagefläche (31) aufweisen, an denen die Klemmkörper (24) aneinander anliegen.

9. Explosionsgeschütztes Gehäuse nach Anspruch 8,
**dadurch gekennzeichnet, dass** die Anlageflächen (31) ebene Flächen sind.

10. Explosionsgeschütztes Gehäuse nach Anspruch 8 oder 9,
**dadurch gekennzeichnet, dass** die Anlageflächen (31) in einer Ebene aneinander anliegen, in der die Längachse (L) verläuft.

11. Explosionsgeschütztes Gehäuse nach einem der Ansprüche 4 bis 10,
**dadurch gekennzeichnet, dass** der Querschnitt des Kanals (25) an den Querschnitt des aufzunehmenden Bauteils (11, 15) angepasst ist.

12. Explosionsgeschütztes Gehäuse nach einem der vorhergehenden Ansprüche,
**dadurch gekennzeichnet, dass** die Klemmfläche (26) der Klemmkörpereinheit (20) in Richtung der Längsachse (L) gesehen zwischen der ersten Axialfläche (27) und einer zweiten Axialfläche (28) der Klemmkörpereinheit (20) angeordnet ist.

13. Explosionsgeschütztes Gehäuse nach Anspruch 12,
**dadurch gekennzeichnet, dass** die Hülse (21) axial im Anschluss an die Innenfläche (36) einen radial nach innen wegragenden Ringflansch (37) aufweist, der der zweiten Axialfläche (28) zugeordnet ist.

14. Explosionsgeschütztes Gehäuse nach einem der Ansprüche 4 bis 13,
**dadurch gekennzeichnet, dass** ein Abschnitt (42) der Außenfläche der Hülse (21) zur Bildung eines zünddurchschlagsicheren Spalts (43) mit einer Öffnung (12, 45) im Gehäuse (14) vorgesehen ist.

## Claims

1. Explosion-proof housing (14) having a wall (13) in which a wall opening (12) is present, through which a component (11, 15) which is rigid in its extension direction is guided outwards from the interior of the housing (14),
having a lead-through device (10) arranged in the wall opening (12), said lead-through device being mounted to be moveable relative to the housing (14) or the component,
wherein a gap (43) which is flameproof is formed between the lead-through device (10) and the wall opening (12) or the component (11, 15),
and wherein the lead-through device (10) is connected to the component (11, 15) to be immoveable, and is arranged to be moveable relative to the housing.

2. Explosion-proof housing according to claim 1,
**characterised in that** the lead-through device (10) has a clamping body unit (20) enclosing the component (11, 15), a sleeve (21) which loads the clamping body unit (20) with a radial clamping force, and a cap (22) which is able to be screwed together with the sleeve.

3. Explosion-proof housing according to claim 1 or 2,
**characterised in that** it is designed in the "pressure-resistant encapsulation" style of ignition-protection.

4. Explosion-proof housing according to one of claims 1 to 3, **characterised in that** the lead-through device (10) has:
- a clamping body unit (20) which has a channel (25) extending along a longitudinal axis (L) to receive a longitudinal section (15a) of the component (11, 15), and which has a conical clamping surface (26) running around the longitudinal axis (L),
- a sleeve (21) which has a conical inner surface (36), the conicity of which is adapted to that of the clamping surface (26) of the clamping body unit (20),
- a cap (22) which is able to be screwed together with the sleeve (21) and which has a pressure surface (53),
- a pressure ring (23) which is arranged between the pressure surface (53) of the cap (22) and a first axial surface (27) of the clamping body unit (20) and is set up to transfer axial forces between the pressure surface (52) and the first axial surface (27).

5. Explosion-proof housing according to claim 4,
**characterised in that** the pressure surface (53) and/or the first axial surface (27) are aligned at an angle to or at right angles to the longitudinal axis (L).

6. Explosion-proof housing according to claim 4 or 5,
**characterised in that** a plain bearing (58) is formed between the pressure ring (23) on the one side and the pressure surface (53) and/or the first axial surface (27) on the other side.

7. Explosion-proof housing according to one of claims 4 to 6,
**characterised in that** a space is present between the sleeve (21) and the pressure ring (23).

8. Explosion-proof housing according to one of claims 4 to 7,
**characterised in that** the clamping body unit (20) has two clamping bodies (24) which each have one contact surface (31), at which the clamping bodies (24) abut onto each other.

9. Explosion-proof housing according to claim 8,
**characterised in that** the contact surfaces (31) are flat surfaces.

10. Explosion-proof housing according to claim 8 or 9,
**characterised in that** the contact surfaces (31) abut onto each other in a plane in which the longitudinal axis (L) runs.

11. Explosion-proof housing according to one of claims 4 to 10,
**characterised in that** the cross-section of the channel (25) is adapted to the cross-section of the component (11, 15) to be received.

12. Explosion-proof housing according to one of the preceding claims,
**characterised in that** the clamping surface (26) of the clamping body unit (20) is arranged between the first axial surface (27) and a second axial surface (28) of the clamping body unit (20), seen in the direction of the longitudinal axis (L).

13. Explosion-proof housing according to claim 12,
**characterised in that** the sleeve (21) has a ring flange (37) projecting away radially inwards, axially in connection with the inner surface (36), said ring flange being allocated to the second axial surface (28).

14. Explosion-proof housing according to one of claims 4 to 13,
**characterised in that** a section (42) of the outer surface of the sleeve (21) is provided in the housing (14) with an opening (12, 45) for the formation of a gap (43) which is flameproof.

## Revendications

1. Boîtier (14) antidéflagrant comprenant une paroi (13) dans laquelle est prévue une ouverture de paroi (12) à travers laquelle un élément de construction (11, 15), qui est rigide dans le sens de sa longueur, est guidé de l'intérieur du boîtier (14) vers l'extérieur,
comprenant un dispositif de traversée (10) qui est placé dans l'ouverture de paroi (12) et est monté avec possibilité de déplacement par rapport au boîtier (14) ou à l'élément de construction,
un joint antidéflagrant (43) étant formé entre le dispositif de traversée (10) et l'ouverture de paroi (12) ou l'élément de construction (11, 15),
et le dispositif de traversée (10) étant relié sans possibilité de déplacement à l'élément de construction (11, 15) et étant disposé avec possibilité de déplacement par rapport au boîtier.

2. Boîtier antidéflagrant selon la revendication 1, **caractérisé en ce que** le dispositif de traversée (10) présente une unité de corps de serrage (20) entourant l'élément de construction (11, 15), une douille (21) sollicitant l'unité de corps de serrage (20) avec une force de serrage radiale, et un capuchon (22) pouvant être vissé à la douille.

3. Boîtier antidéflagrant selon la revendication 1 ou 2, **caractérisé en ce qu'**il est réalisé avec la protection "blindage antidéflagrant".

4. Boîtier antidéflagrant selon l'une des revendications 1 à 3, **caractérisé en ce que** le dispositif de traversée (10) présente :
- une unité de corps de serrage (20) qui présente un conduit (25), s'étendant le long d'un axe longitudinal (L) et destiné à recevoir une portion longitudinale (15a) de l'élément de construction (11, 15), et une surface de serrage (26) conique s'étendant autour de l'axe longitudinal (L),
- une douille (21) qui présente une surface interne (36) conique dont la conicité est adaptée à celle de la surface de serrage (26) de l'unité de corps de serrage (20),
- un capuchon (22) qui peut être vissé à la douille (21) et qui présente une surface de poussée (53),
- une bague de poussée (23) qui est disposée entre la surface de poussée (53) du capuchon (22) et une première surface axiale (27) de l'unité de corps de serrage (20) et est conçue pour transmettre des forces axiales entre la surface de poussée (52) et la première surface axiale (27).

5. Boîtier antidéflagrant selon la revendication 4, **caractérisé en ce que** la surface de poussée (53) et/ou la première surface axiale (27) sont orientées en biais ou à angle droit par rapport à l'axe longitudinal (L).

6. Boîtier antidéflagrant selon la revendication 4 ou 5, **caractérisé en ce qu'**un palier lisse (58) est formé entre la bague de poussée (23), d'une part, et la surface de poussée (53) et/ou la première surface axiale (27), d'autre part.

7. Boîtier antidéflagrant selon l'une des revendications 4 à 6, **caractérisé en ce qu'**il existe un espace entre la douille (21) et la bague de poussée (23).

8. Boîtier antidéflagrant selon l'une des revendications 4 à 7, **caractérisé en ce que** l'unité de corps de serrage (20) présente deux corps de serrage (24) qui présentent chacun une surface d'appui (31), par lesquelles les corps de serrage (24) sont appliqués l'un contre l'autre.

9. Boîtier antidéflagrant selon la revendication 8, **caractérisé en ce que** les surfaces d'appui (31) sont des surfaces planes.

10. Boîtier antidéflagrant selon la revendication 8 ou 9, **caractérisé en ce que** les surfaces d'appui (31) sont appliquées l'une contre l'autre dans un plan dans lequel s'étend l'axe longitudinal (L).

11. Boîtier antidéflagrant selon l'une des revendications 4 à 10, **caractérisé en ce que** la section transversale du conduit (25) est adaptée à la section transversale de l'élément de construction (11, 15) à loger.

12. Boîtier antidéflagrant selon l'une des revendications précédentes, **caractérisé en ce que** la surface de serrage (26) de l'unité de corps de serrage (20), vue dans le sens de l'axe longitudinal (L), est disposée entre la première surface axiale (27) et une deuxième surface axiale (28) de l'unité de corps de serrage (20).

13. Boîtier antidéflagrant selon la revendication 12, **caractérisé en ce que** la douille (21) présente, axialement à la suite de la surface interne (36), une collerette annulaire (37) qui fait saillie radialement vers l'intérieur et est associée à la deuxième surface axiale (28).

14. Boîtier antidéflagrant selon l'une des revendications 4 à 13, **caractérisé en ce qu'**une portion (42) de la surface externe de la douille (21) est prévue pour la formation d'un joint antidéflagrant (43) avec une ouverture (12, 45) dans le boîtier (14).
